# EUROPEAN PATENT SPECIFICATION

(11) **EP 1 570 257 B1**
(45) Date of publication and mention of the grant of the patent: **21.10.2009**
(21) Application number: 03774255.8
(22) Date of filing: 19.11.2003
(51) Int. Cl.: G01N 22/00, G01R 29/08

(54) **SYSTEM FOR MEASURING THE SPECIFIC ABSORPTION RATE (SAR) COMPRISING A PLURALITY OF MICROANTENNAS AND ASSOCIATED IC CHIPS IN A PHANTOM**
SYSTEM ZUR MESSUNG DER SPEZIFISCHEN ABSORPTIONSRATE (SAR) BESTEHEND AUS EINER MEHRZAHL VON MIKRO-ANTENNEN UND ZUGEORDNETEN IC-CHIPS IN EINEM PHANTOM
SYSTEME DE MESURE DU TAUX D'ABSORPTION SPECIFIQUE (SAR) COMPRENANT UNE PLURALITE DE MICRO-ANTENNES ET PUCES A CIRCUIT INTEGRE ASSOCIEES DANS UN FANTOME

(30) Priority: 22.11.2002 KR 2002073197
(43) Date of publication of application: 07.09.2005
(73) Proprietor: The Industry & Academic Cooperation in Chungnam National University (IAC), 305-764 Daejeon-City (KR); Amplet Inc., Tokyo, 110-0016 (JP); Vigitasystem Inc., Yokohama-city, Kanagawa 222-0033 (JP)
(72) Inventor: WOO, Jong-Myung, 305-764 Daejeon-city (KR)
(74) Representative: Braun, André jr.
(86) International application number: PCT/KR2003/002492
(87) International publication number: WO 2004/048949

(56) References cited:
- EP-A2- 0 702 932
- WO-A-01/86311
- JP-A- 07 092 110
- JP-A- 11 142 351
- JP-A- 2000 097 878
- US-A- 5 789 929

## Description

### BACKGROUND OF THE INVENTION

### (a) Field of the Invention

The present invention relates to an SAR measurement system and a method of operating the same, and more particularly, to an SAR measurement system and a method of operating the same which speedily measure the pattern of electromagnetic waves to be applied to the human body using micro-antennas and IC chips.

### (b) Description of the Related Art

Recently, as the harmful effect of electromagnetic wave to the human body has been spotlighted, it becomes a critical factor in the technology development to intercept or reduce the electromagnetic wave of the electric and electronic appliances. Particularly in the case of cellular phones which were distributed to the peoples nearly one by one, as they are used in contact with the human body (the head), the consumers' cooperative society or the national health agency strictly regulate the radiation of the electromagnetic wave thereof.

In this connection, with the cellular phone manufacturers, the radiation of the electromagnetic wave is tested at the early development stage, and it is legislated by the relevant government agency that the products could be marketed only when they reach a predetermined regulatory value with the sampling test. Furthermore, throughout the world, the import and sales of mobile handsets are allowed only to the products with the electromagnetic wave radiation below a predetermined regulatory value. Therefore, it is necessary that the export-oriented manufacturers should correctly measure the electromagnetic wave radiation of their products one by one.

In order to evaluate the harmful effect of the electromagnetic wave to the human body, the relevant international or national agency present the specific absorption rate (SAR) as a standard for measuring the energy absorbed per the unit mass of biological tissue when it is exposed to the electromagnetic wave. For example, the FCC of U. S. A., Canada and Australia make the SAR regulation value be 1.6W/kg per 1g of cell. In Europe (CENELFC) and Japan, it is recommended that 2.0W/kg should be attributed to 10g of cell, and in Korea, the maximum SAR regulation value per 1 g of arbitrary body tissue averaged in the frequency range of 100kHz-10GHz is determined to be 1.6W/kg.

It has been currently proposed as an SAR measuring technique that a phantom should be used with probes therein. The electric field intensity absorbed into the phantom from an electronic appliance, such as a cellular phone, is detected by the probes.

The phantom refers to a structure with a sham tissue conforming to the electrical characteristics of the body tissue, and an outer skin incrusting the sham tissue. The outer skin is outlined with the anatomical configuration of the human body, and the sham tissue is made with homogeneous liquid conformed to the electrical characteristic of the head tissue in relation to the measurement frequency.

The probes are formed with three micro dipoles of 2-4mm proceeding perpendicular to each other to measure the electric field intensity incident thereto. They are structured to absorb the SAR of 10mW/kg-100W/kg in the measurement frequency band of 300MHz-3GHz.

Furthermore, a control system is provided to three-dimensionally measure the electric field pattern in the whole exposed area of the phantom, and to control the displacement of the probes within the displacement precision of ±0.1 mm or less.

With the above-described SAR measurement technique, the measuring of the SAR of cellular phones using the phantom and the probes is made by detecting the SAR value or the electric field intensity at the reference point, and measuring the surface SAR pattern of the phantom by a large distance. The minute volume SAR pattern in the phantom is then measured by a small distance. The SAR value or the electric field intensity is again detected at the reference point, and compared with the previously measured value to identify whether it is within the error range or not. If yes, the antenna state and the test position of the cellular phone are varied, and the measurement is repeated. The SAR is measured at the low frequency band and at the high frequency band, and the highest SAR value is determined as the maximum SAR value.

With the above-like SAR measurement technique, the SAR is measured while continuously varying the insert positions of the probes to make the surface pattern measurement, and the same process is again conducted to make the minute volume pattern measurement. As such a process is repeated while varying the antenna state and the test position, it is considerably time consumed (for instance, three hours) to make the SAR for a single target product. Accordingly, the cellular phone manufacturers cannot make the SAR measurement with respect to all of the products, but must depend upon the sampling test. Furthermore, even in the case of the sampling test, it is difficult to make sampling with respect to large numbers of products, and hence, to make precise quality control thereof.

The output of the products as well as the import and exports thereof can be made only when the SAR information measured at the authorized test agency per a predetermined production rot is presented. With the respective manufacturers, the output of the products should be prohibited till the SAR measurement is completed, and with the time-consuming measurement, a considerable delay is made in the output of the products.

Meanwhile, the phantom is not wholly made in a precise manner. That is, the outer skin is made with respect to only three sides thereof except for one side, and a liquid sham tissue is contained within the outer skin. The probes move in the liquid sham tissue by a robot, and the SAR is measured while the one side of the phantom being in an opening state. Therefore, it is difficult to obtain the measurement value approximate to the practical state, and the error range becomes significant.

Furthermore, as the probes are continuously inserted into the sham tissue and withdrawn therefrom, the liquid sham tissue is contaminated, and it becomes impossible to use it for a long time. This causes frequent replacements of the high cost sham tissue.

### SUMMARY OF THE INVENTION

It is an object of the present invention to provide an SAR measurement system which can precisely measure the SAR approximate to the practical pattern using micro-antennas and IC chips within a short time.

It is another object of the present invention to provide an SAR measurement system which can use a phantom semi-permanently.

These and other objects may be achieved by an SAR measurement system with the following features.

The SAR measurement system includes a phantom having a sham tissue formed with a homogeneous material conformed to the electrical characteristic of the human body tissue in relation to the measurement frequency, and an outer skin formed with the anatomical structure of the human body to incrust the sham tissue. A plurality of measurement modules are uniformly arranged within the phantom each with an IC chip for processing the positional information and measured values to generate signals, and an antenna for transmitting the signals from the IC chip, receiving frequency signals from the outside and generating induced power for driving the IC chip, and measuring the SAR absorbed into the sham tissue and transmitting the measured SAR values to the IC chip. A measurement controller receives the positional information and the measured values from the antennas of the measurement modules, and processes the received data.

In a method of measuring the SAR, a plurality of measurement modules are arranged at the inside of a phantom with a sham tissue in a predetermined pattern. Each module has an IC chip for processing positional information and measured values to generate signals, and an antenna for transmitting the signals from the IC chip, receiving frequency signals from the outside to generate induced power for driving the IC chip, and measuring the SAR absorbed into the sham tissue to transmit the measured SAR values to the IC chip. The target electronic product is mounted at a predetermined position of the phantom with the measurement modules. The electronic product is operated together with a measurement controller. The measurement controller receives the positional information and the measured values from the antennas of the measurement modules at the measurement controller, and processes the received data.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or the similar components, wherein:
Fig. 1 is a schematic perspective view of a SAR measurement system according to a preferred embodiment of the present invention;
Fig. 2 is a front elevation view of the SAR measurement system shown in Fig. 1 where measurement modules are arranged at the phantom;
Fig. 3 is a plan view of the measurement module with an antenna and an IC chip shown in Fig. 2;
Fig. 4 is a schematic perspective view of a first example of the antenna shown in Fig. 3;
Fig. 5 is a schematic perspective view of a second example of the antenna shown in Fig. 3;
Fig. 6 is a schematic perspective view of a third example of the antenna shown in Fig. 3;
Fig. 7 is a schematic perspective view of a fourth example of the antenna shown in Fig. 3;
Fig. 8 is an exploded perspective view of a fifth example of the antenna shown in Fig. 3;
Fig. 9 is a bottom perspective view of the fifth example of the antenna shown in Fig. 8;
Fig. 10 is a graph measuring the radiation pattern of an E-plane using the second example of the antenna shown in Fig. 5;
Fig. 11 is a perspective view of the antenna state for measuring the x-y plane in the radiation pattern shown in Fig. 10;
Fig. 12 is a perspective view of the antenna state for measuring the z-y plane in the radiation pattern shown in Fig. 10;
Fig. 13 is a perspective view of the antenna state for measuring the z-x plane in the radiation pattern shown in Fig. 10; and
Fig. 14 is a block diagram illustrating the operations of the antenna and the IC chip shown in Fig. 3.

### DETAILED DESCRIPTION OF THE PREFERRED EMBODIMENTS

Preferred embodiments of this invention will be explained with reference to the accompanying drawings.

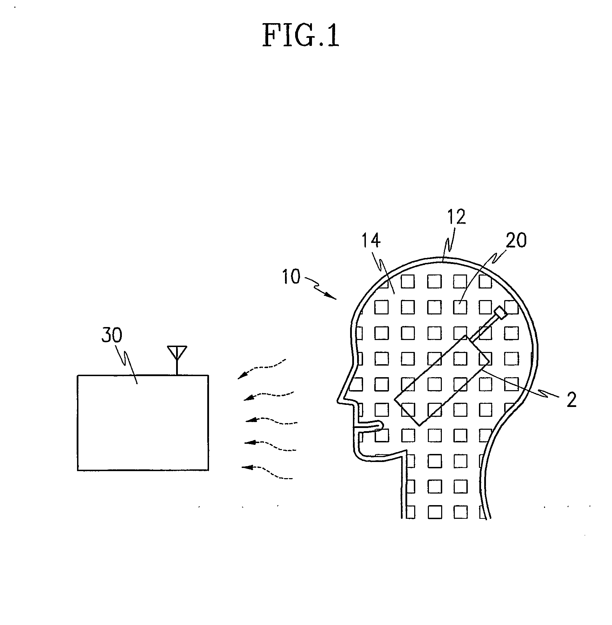

As shown in Figs. 1 to 3, the SAR measurement system includes a phantom 10 formed with the anatomical structure of the human body, and having a sham tissue 14 formed with a homogeneous material conformed to the electrical characteristic of the human boy tissue in relation to the measurement frequency, and an outer skin 12 incrusting the sham tissue 14. A plurality of measurement modules 20 are arranged within the phantom 10 in a predetermined pattern each with an IC chip 22 and an antenna 24. The IC chip 22 processes the positional information and the measured value, and generates relevant signals. The antenna 24 transmits the signals from the IC chip 22, and receives frequency signals from the outside to generate the driving induced power. The antenna 24 measures the SAR absorbed into the sham tissue 14, and transmits the measured value to the IC chip 22. The SAR measurement system further includes a measurement controller 30 receiving the signals from the antenna 24 and processing the positional information and the measured value in the respective measurement modules 20.

The sham tissue 14 may be formed with homogeneous liquid conformed to the electrical characteristic of the average head tissue in relation to the measurement frequency, or with artificial bones, artificial brain tissues, artificial blood, and artificial gray cells such that it is similar to the head of the practical human body.

As any probe is not inserted into the phantom 10 to make the desired measurement, it becomes possible to make the phantom 10 similar to the head of the practical human body. Accordingly, it is also possible to make the SAR measurement most approximate to the practical level.

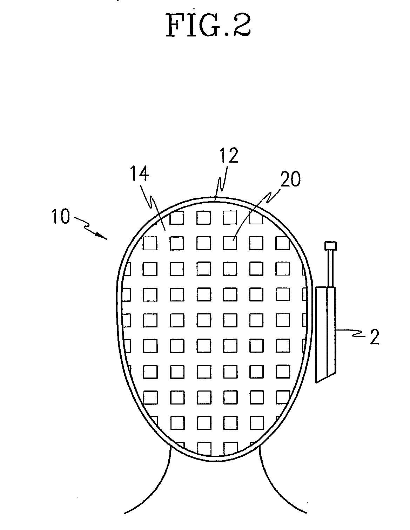

As shown in Figs. 1 and 2, the measurement modules 20 are installed at the respective measurement locations determined during the process of forming the sham tissue 14.

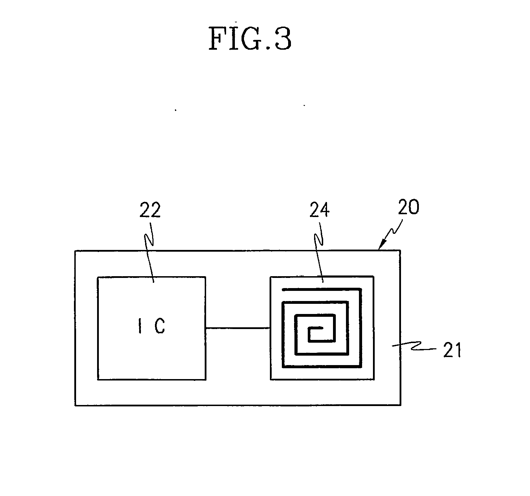

As shown in Fig. 3, the measurement module 20 has a substrate 21 shaped with a rectangle, a circle or an oval having a length or a maximum diameter of 2-4mm. The IC chip 22 and the antenna 24 are mounted on the substrate 21 by a surface mounting technique.

Alternatively, the IC chip 22 and/or the antenna 24 may be directly formed at the substrate 21 by printing or photolithography.

The IC chip stores the number peculiar to its location. The IC chip 22 is programmed such that it transforms the values related to the intensity of the frequency signals or the dimension of the induced power at the antenna 24 into digital signals, and transmits them via the antenna 24.

As the IC chip 22 is currently made up to several micrometers, it can be mounted on the substrate 21 with a size of 2-4mm.

An amplification circuit is preferably installed at the IC chip 22 to amplify the micro-scaled frequency signal or induced power, and obtain precise measurement results.

The IC chip 22 is programmed such that it combines the measured value from the antenna 24 with the native numbers in a predetermined sequence to generate a predetermined measurement signal, and transmits it via the antenna 24 together with the trigger signal.

The antenna 24 has a micro-dimensioned size such that it can be mounted on the substrate 21 with a size of 2-4mm.

With the conventional dipole antenna, micro-strip antenna and dielectric chip antenna, it is impossible to make the antenna with a size of 2mm or less.

In this respect, a new micro-dimensioned antenna structure is presented with the inventive system.

In the SAR measurement system according to a preferred embodiment of the present invention, the antenna 24 has wires spirally wound on two or more-leveled imagined planes, respectively. The wires formed at the imagined plane neighbors are connected to each other at their central ends or peripheral ends to form a single line.

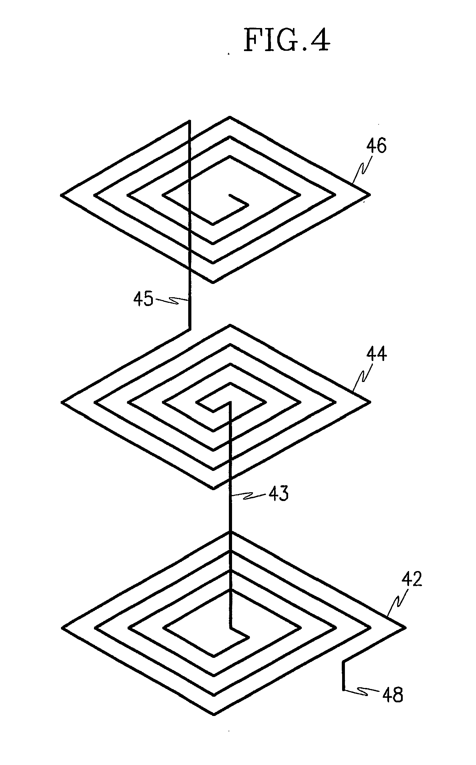

As shown in Fig. 4, the antenna 24 has wires 42, 44 and 46 spirally wound on first to third imagined planes. In order to form a single line, the wires 42 and 44 formed at the first and second imagined planes are connected to each other at their central ends using an interconnection line 43. The wires 44 and 46 formed at the second and third imagined planes are connected to each other at their peripheral ends using an interconnection line 45.

A feeder 48 is connected to the peripheral end of the wire 42 formed at the first bottommost imagined plane.

If the wires 42, 44 and 46 and the interconnection lines 43 and 45 are elongated by holding the peripheral end of the conductive line 46 and the feeder 48, the whole wire portions make formation of a single line.

The outline of the wires 42, 44 and 46 may be formed with various shapes, such as a rectangle, a circle, an oval, a hexagon, or an octagon.

It is preferable to shorten the length of the interconnection lines 43 and 45 as much as possible.

Furthermore, it is preferable to form an insulating layer (not shown) between the wires 42, 44 and 46 to prevent the possible short-circuiting.

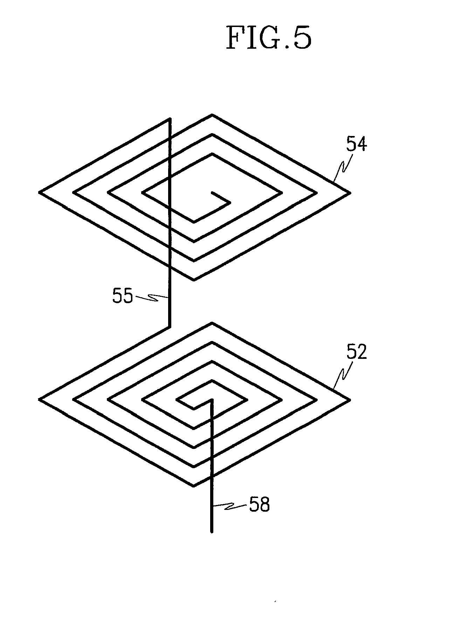

Alternatively, as shown in Fig. 5, the antenna 24 may have wires 52 and 54 spirally wound on the two-leveled imagined planes, respectively. The wires 52 and 54 are connected to each other at their peripheral ends using an interconnection line 55. A feeder 58 is connected to the central end of the wire 52 formed at the bottom imagined plane.

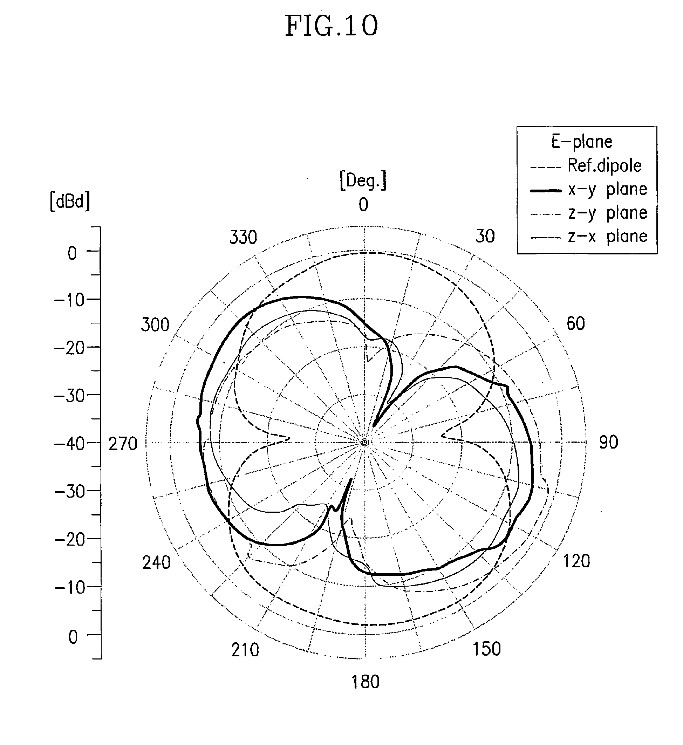

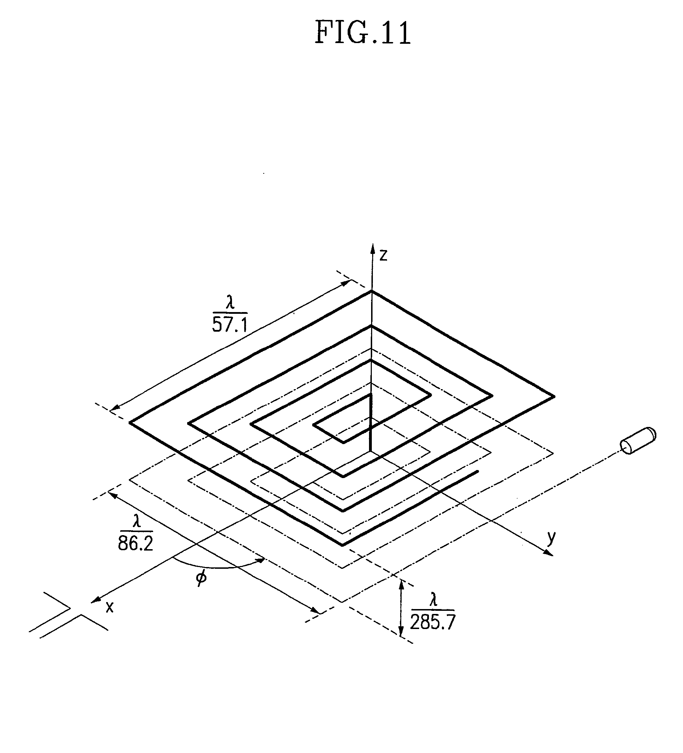

Fig. 10 illustrates the radiation pattern measurement where the antennas 24 are arranged in various directions as illustrated in Figs. 11 to 13, and the radiation pattern of E-plane is measured at the central frequency of 390MHz.

The radiation pattern is measured by establishing the distance between the transmitter side of the antenna and the receiver side thereof to be 122cm, and the height thereof identically to be 204cm. The antenna 24 is structured such that the horizontal length of the outermost spiral portion thereof is established to be λ/86.2mm with respect to the wavelength (λ), and the vertical length thereof to be λ/57.1 mm. The antenna portions are wound four times with the same distance, and the height of the two imagined planes is established to be λ/285.7mm.

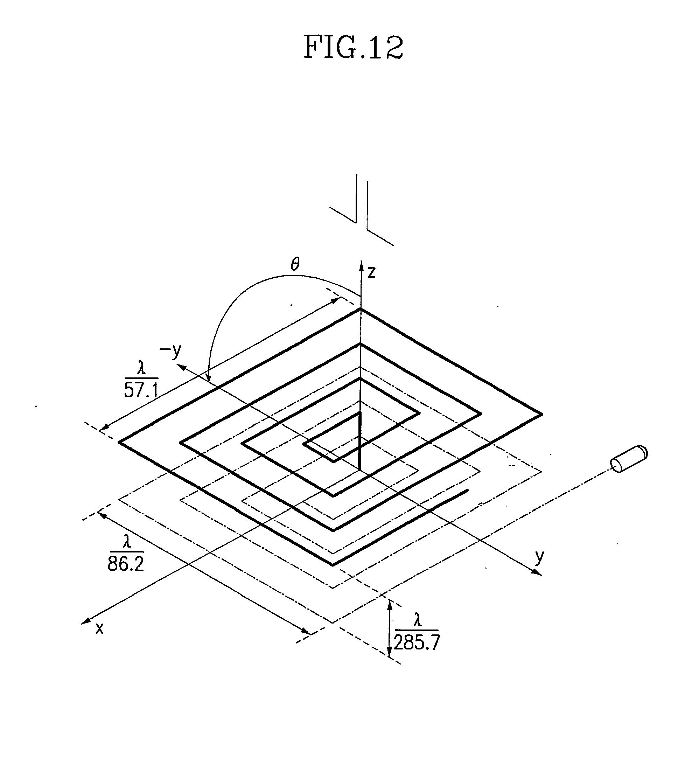

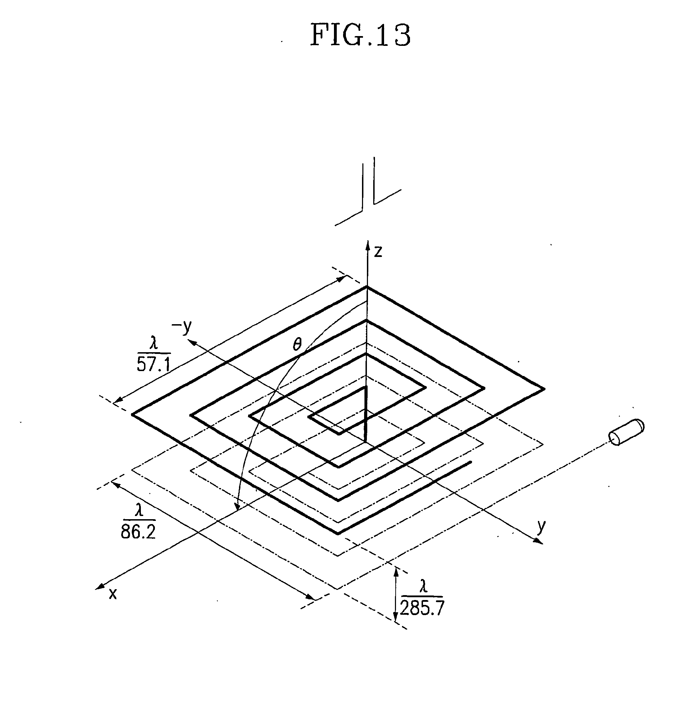

The x-y plane of Fig. 10 is measured by installing the antenna 24 to be in the state illustrated in Fig. 11, compared to the conventional dipole antenna. The z-y plane is measured by installing the antenna 24 to be in the state illustrated in Fig. 12. The z-x plane is measured by installing the antenna 24 in the state illustrated in Fig. 13.

As shown in Fig. 10, the three cases all exhibit a radiation pattern similar to that of the dipole antenna.

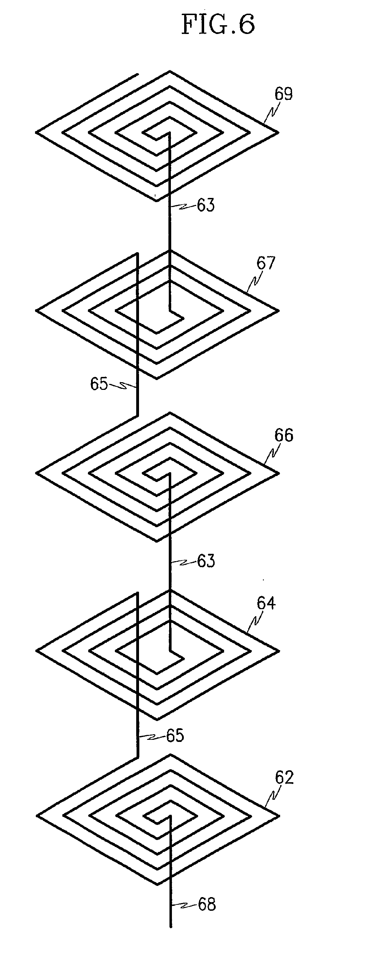

As shown in Fig. 6, the antenna 24 may have five wires 62, 64, 66, 67 and 69 spirally wound on the five-leveled imagined planes. The wires 62 and 64 formed at the first and second imagined plane neighbors as well as the wires 66 and 67 formed at the third and fourth imagined plane neighbors are connected to each other at their peripheral ends using interconnection lines 63. The wires 64 and 66 formed at the second and third imagined plane neighbors as well as the wires 67 and 69 formed at the fourth and fifth imagined plane neighbors are connected to each other at their central ends using interconnection lines 65. A feeder 68 is connected to the central end of the wire 62 formed at the bottommost imagined plane.

As described above, the antenna is structured such that the wires formed at the imagined plane neighbors are connected to each other repeatedly at their central ends and at their peripheral ends in an alternate manner while wholly forming a single line.

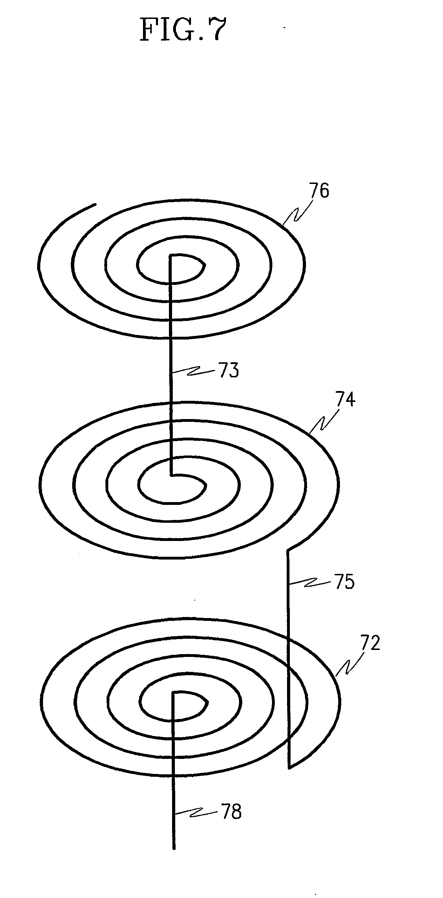

As shown in Fig. 7, the antenna 24 may be structured such that the wires 72, 74 and 76 formed at the imagined planes are spirally wound each in the shape of an oval, and connected to each other using interconnection lines 73 and 75 while forming a single line. A feeder 78 is connected to the bottommost wire 72.

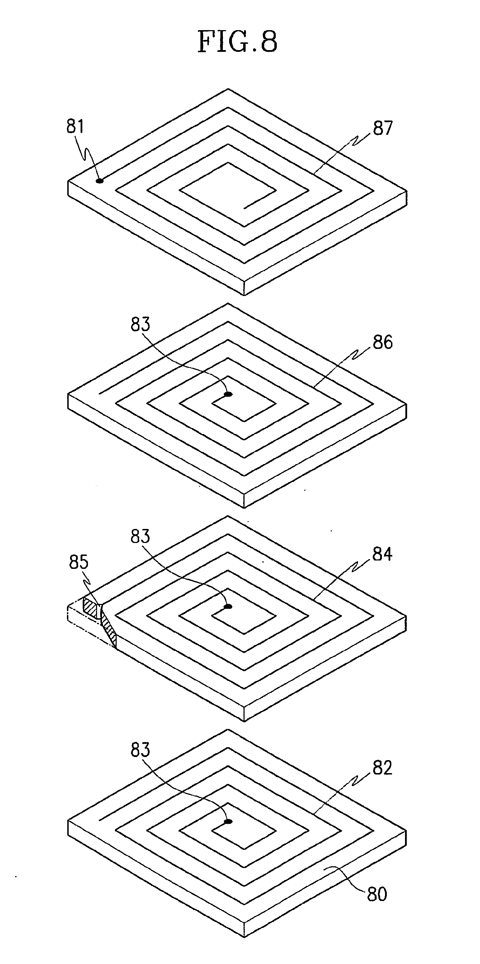

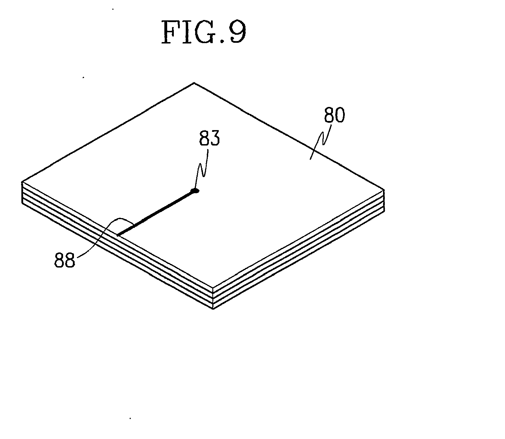

As shown in Figs. 8 and 9, the antenna 24 may be structured such that spiral wires 82, 84, 86 and 87 are printed at the one-sided portions of the four dielectric thin films 80. Through holes 83 are formed at the first and third-leveled dielectric thin films such that they are connected to the central ends of the wires 82 and 86. Through holes 85 are formed at the second and fourth-leveled dielectric thin films such that they are connected to the peripheral ends of the wires 84 and 87. The through holes 83 and 85 are filled with conductive powder, and the four dielectric thin films are closely adhered to each other to form a single chip. The chip is heated at a predetermined temperature, and the conductive powder in the through holes 83 and 85 are molten so that the wire neighbors are connected to each other to form a single line.

As described above, the dielectric thin film where the through hole is connected to the central end of the wire, and the dielectric thin film where the through hole is connected to the peripheral end of the wire are alternately deposited.

Furthermore, as shown in Fig. 9, a feeder 88 is formed at the bottom side of the bottommost dielectric thin film such that it is connected to the through hole 83.

The spiral wires 82, 84, 86 and 87 and the feeder 88 made at the dielectric thin films are formed by a printing technique or a photolithography technique commonly used in the semiconductor manufacturing process.

When the antenna 24 is formed with the above structure, it is possible to make the antenna with a micro size such that it can be mounted on the substrate of 2-4mm together with the IC chip 22.

A receiver is installed at the measurement controller 30 to receive the signals from the antenna 24. The measurement controller 30 transforms the received signals, and displays them with a display device, such as a monitor. It stores the information about the positions of the measurement module 20 as well as the measured SAR value.

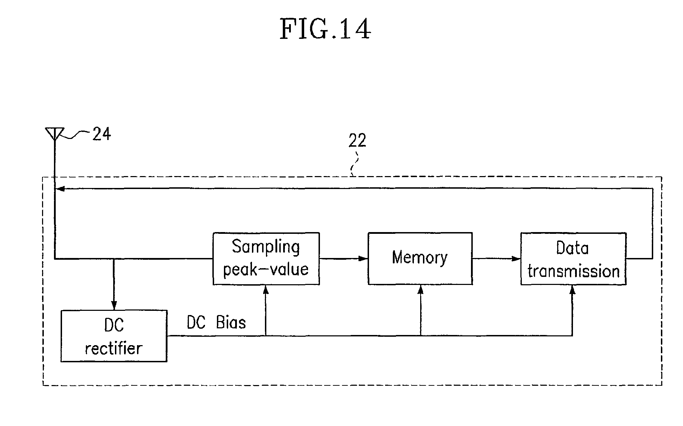

A method of measuring the SAR of electronic products (for example, the cellular phones) using the above-structured SAR measurement system will be explained with reference to Figs. 1 to 14.

First, a phantom 10 is made such that measurement modules 20 each with an IC chip 22 storing the specific position information and an antenna 24 are mounted at predetermined locations of a sham tissue 14.

A cellular phone 2 is positioned at the predetermined location of the phantom 10, and operated.

When the cellular phone 2 is operated, electromagnetic wave is generated, and transmitted in all directions. The antenna 24 of the measurement module 20 installed within the phantom 10 receives the electromagnetic wave from the cellular phone 2, and a part of the received electromagnetic wave generates induced power (using an RF-DC rectifier) to drive the IC chip 22.

The IC chip 22 of the measurement module 20 samples the intensity of the frequency or the dimension of the induced power from the antenna 24, and stores and modulates it (using PSK and/or FSK modulation or CDMA). The IC chip 22 transmits the positional information and the modulated signals through the antenna 24.

The measurement controller 30 receives the signals from the antenna 24, and processes the data of the positional information and the modulated signals at the respective measurement modules 20 to compute and store the SAR measurement value. The SAR measurement value is output by a display device or a printer.

With the above-structured SAR measurement system, when the target electronic product (such as a cellular phone) is operated, the information about the positions of the respective measurement modules and the measured values are simultaneously input into the measurement controller, thereby measuring the SAR in real time.

As the processing time is short, the SAR measurement can be made for all the electronic articles to be produced, and the quality control thereof can be made properly. Furthermore, even in case the output of the products is allowed only when the SAR information measured by the nationally authorized test agency in a predetermined production rot is presented, as the measurement time is very short, any delay is not made in the output of the products.

Furthermore, with the inventive SAR measurement system, measurement modules are distributed over the entire area of the phantom uniformly. Accordingly, it becomes possible to measure and tabulate or simulate the SAR pattern clearly, thereby using the data for the product improvement purpose.

With the inventive SAR measurement system, as any probe is not inserted into or withdrawn from the phantom, it becomes possible to make the phantom similar to the practical human body, and to measure the SAR more precisely and correctly with the phantom.

While the present invention has been described in detail with reference to the preferred embodiments, those skilled in the art will appreciate that various modifications and substitutions can be made thereto without departing from the spirit and scope of the present invention as set forth in the appended claims.

## Claims

1. A specific absorption rate (SAR) measurement system comprising:
a phantom having a sham tissue formed with a homogeneous material conformed to the electrical characteristic of the human body tissue in relation to the measurement frequency, and an outer skin formed with the anatomical structure of the human body to incrust the sham tissue;
a plurality of measurement modules uniformly arranged within the phantom each with an IC chip for processing the positional information and measured values to generate signals, and an antenna for transmitting the signals from the IC chip, receiving frequency signals from the outside and generating induced power for driving the IC chip, and measuring the SAR absorbed into the sham tissue and transmitting the measured SAR to the IC chip; and
a measurement controller for receiving the positional information and the measured values from the antennas of the measurement modules, and processing the received data.

2. The SAR measurement system of claim 1 wherein the sham tissue is formed with artificial bones, artificial brain tissues, artificial blood and artificial gray cells, similar to the head of the practical human body.

3. The SAR measurement system of claim 1 or 2 wherein the measurement modules are arranged at the respective measuring positions determined during the process of making the sham tissue.

4. The SAR measurement system of claim 1 wherein the IC chip and the antenna are mounted on a substrate shaped with a rectangle, a circle or an oval, and having a length or a maximum diameter of 2-4mm.

5. The SAR measurement system of claim 1 or 4 wherein the antenna has wires spirally wound on two or more-leveled imagined planes, and the wires formed at the imagined plane neighbors are connected to each other at the central ends or peripheral ends thereof to form a single line.

6. The SAR measurement system of claim 5 wherein a feeder is connected to the peripheral end or the central end of the wire formed at the bottommost imagined plane.

7. The SAR measurement system of claim 5 wherein the wire formed at the imagined plane is shaped with a rectangle, a circle, an oval, a hexagon or an octagon while being spirally wound forward or backward.

8. The SAR measurement system of claim 5 wherein an insulating layer is formed between the conductive lines to prevent the possible short-circuiting.

9. The SAR measurement system of claim 1 or 4 wherein the antenna is structured such that spiral wires are formed at the one-sided portions of dielectric thin films, through holes are formed at the respective dielectric thin films such that the through holes are alternately connected to the central end or the peripheral end of the wire, the dielectric thin films are deposited while filling the through holes with conductive powder, and a feeder is formed at the bottom side of the bottommost dielectric thin film such that the feeder is connected to the through hole thereof.

10. A method of measuring a specific absorption rate (SAR) comprises the steps of:
arranging a plurality of measurement modules at the inside of a phantom with a sham tissue in a predetermined pattern, each module having an IC chip for processing positional information and measured values to generate signals, and an antenna for transmitting the signals from the IC chip, receiving frequency signals from the outside to generate induced power for driving the IC chip, and measuring the SAR absorbed into the sham tissue to transmit the measured SAR values to the IC chip;
mounting the target electronic product at a predetermined position of the phantom with the measurement modules; and
operating the electronic product and a measurement controller, receiving the positional information and the measured values from the antennas of the measurement modules at the measurement controller, and processing the received data.

## Patentansprüche

1. System zur Messung der spezifischen Absorptionsrate (SAR), umfassend:
ein Phantom mit einem simulierten Gewebe, das mit einem homogenen Material gebildet ist, welches mit den elektrischen Eigenschaften des menschlichen Körpergewebes in Bezug auf die Messfrequenz übereinstimmt, sowie mit einer Außenhaut mit der anatomischen Struktur des menschlichen Körpers, um das simulierte Gewebe zu umhüllen,
eine Vielzahl von im Inneren des Phantoms gleichmäßig angeordneten Messmodulen mit jeweils einem IC-Chip zum Verarbeiten der Positionsinformationen und Messwerte, um Signale zu erzeugen und mit einer Antenne zur Übertragung der Signale aus dem IC-Chip, zum Empfang von Frequenzsignalen von aussen und zur Erzeugung von induzierter Energie zum Betrieb des IC-Chips und zur Messung der von dem simulierten Gewebe absorbierten SAR und zur Übertragung der gemessenen SAR an den IC-Chip,
eine Messsteuerung, um die Positionsinformationen und die Messwerte von den Antennen der Messmodule zu empfangen und die empfangenen Daten zu verarbeiten.

2. SAR-Messsystem nach Anspruch 1, bei dem das simulierte Gewebe dem Kopf des realen menschlichen Körpers ähnelnd mit künstlichen Knochen, künstlichem Hirngewebe, künstlichem Blut und künstlicher grauer Substanz gebildet ist.

3. SAR-Messsystem nach Anspruch 1 oder 2, bei dem die Messmodule an den während des Verfahrens zur Herstellung des simulierten Gewebes bestimmten jeweiligen Messpositionen angeordnet sind.

4. SAR-Messsystem nach Anspruch 1, bei dem der IC-Chip und die Antenne auf einem Substrat angebracht sind, das die Form eines Rechtecks, eines Kreises oder eines Ovals hat und eine Länge oder einen maximalen Durchmesser von 2-4 mm aufweist.

5. SAR-Messsystem nach Anspruch 1 oder 4, bei dem die Antenne Drähte aufweist, die auf zwei- oder mehrstufigen gedachten Ebenen spiralförmig gewunden sind und wobei die in den benachbarten gedachten Ebenen gebildeten Drähte an ihren zentralen oder peripheren Enden zur Bildung einer einzigen Leitung miteinander verbunden sind.

6. SAR-Messsystem nach Anspruch 5, bei dem eine Zuleitung mit dem peripheren Ende oder dem zentralen Ende des an der untersten gedachten Ebene gebildeten Drahtes verbunden ist.

7. SAR-Messsystem nach Anspruch 5, bei dem der an der gedachten Ebene gebildete Draht wie ein Rechteck, ein Kreis, ein Oval, ein Sechseck oder ein Achteck geformt ist und dabei spiralförmig vorwärts oder rückwärts gewunden ist.

8. SAR-Messsystem nach Anspruch 5, bei dem zwischen den Leiterbahnen eine Isolationsschicht gebildet ist, um einen möglichen Kurzschluss zu verhindern.

9. SAR-Messsystem nach Anspruch 1 oder 4, bei dem die Antenne derart ausgebildet ist, dass an den einseitigen Teilstücken der dielektrischen Dünnschichten spiralförmige Drähte gebildet sind, dass Durchgangsöffnungen an den jeweiligen dielektrischen Dünnschichten derart gebildet sind, dass die Durchgangsöffnungen wechselweise mit dem zentralen Ende oder mit dem peripheren Ende des Drahtes verbunden sind, dass beim Abscheiden der dielektrischen Dünnschichten die Durchgangsöffnungen mit leitfähigem Pulver ausgefüllt werden und an der Unterseite der untersten dielektrischen Dünnschicht eine Zuleitung derart gebildet ist, dass die Zuleitung mit deren Durchgangsöffnung verbunden ist.

10. Verfahren zur Messung einer spezifischen Absorptionsrate (SAR), die folgenden Schritte umfassend:
im Inneren eines mit einem simulierten Gewebe versehenen Phantoms wird eine Vielzahl von Messmodulen gleichmäßig angeordnet, wobei jedes Modul einen IC-Chip zur Verarbeitung von Positionsinformationen und Messwerten und zur Erzeugung von Signalen umfasst, sowie eine Antenne zur Übertragung der Signale aus dem IC-Chip, zum Empfang von Frequenzsignalen von aussen zur Erzeugung induzierter Energie für den Betrieb des IC-Chips und zur Messung der von dem simulierten Gewebe absorbierten SAR zur Übertragung der gemessenen SAR an den IC-Chip;
das elektronische Zielprodukt wird an einer vorbestimmten Position des Phantoms mit den Messmodulen angebracht und
das elektronische Produkt und eine Messsteuerung werden betrieben, die Positionsinformationen und die Messwerte von den Antennen der Messmodule werden an der Messsteuerung empfangen und die empfangenen Daten werden verarbeitet.

## Revendications

1. Système de mesure du taux d'absorption spécifique (TAS) comprenant :
un fantôme ayant un tissu simulé étant formé d'un matériau homogène, qui est conforme à la caractéristique électrique du tissu de corps humain par rapport à la fréquence de mesure, une peau extérieure avec la structure anatomique du corps humain pour envelopper le tissu simulé ;
une pluralité de modules de mesure disposés régulièrement dans le fantôme et dont chacun comporte une puce à circuit intégré permettant de traiter les informations de positionnement et les valeurs mesurées pour générer des signaux, ainsi qu'une antenne pour transmettre les signaux provenant de la puce à circuit intégré, recevant des signaux de fréquence en provenance de l'extérieur et générant de la puissance induite pour alimenter la puce à circuit intégré et mesurant le TAS absorbé dans le tissu simulé et transmettant le TAS mesuré à la puce à circuit intégré ; et
une unité de commande de mesure destinée à recevoir les informations de positionnement et les valeurs mesurées des antennes des modules de mesure et à traiter les données reçues.

2. Système de mesure du TAS selon la revendication 1 où le tissu simulé est formé avec des os artificiels, du tissu cérébral artificiel, du sang artificiel et de la substance grise artificielle, similaire à la tête du corps humain réel.

3. Système de mesure du TAS selon la revendication 1 ou 2 où les modules de mesure sont disposés dans les positions de mesure respectives déterminées au cours du procédé de réalisation du tissu simulé.

4. Système de mesure du TAS selon la revendication 1 où la puce à circuit intégré et l'antenne sont montées sur un substrat qui présente la forme d'un rectangle, d'un cercle ou d'un ovale et qui a une longueur ou un diamètre maximal de 2-4 mm.

5. Système de mesure du TAS selon la revendication 1 ou 4 où l'antenne présente des fils enroulés en spirale sur des plans imaginaires à deux ou plusieurs étages et où les fils formés sur les plans imaginaires adjacents sont connectés entre eux à leurs extrémités centrales ou à leurs extrémités périphériques pour former une ligne unique.

6. Système de mesure du TAS selon la revendication 5 où une ligne d'alimentation est connecté à l'extrémité périphérique ou à l'extrémité centrale du fil formé sur le plan imaginaire le plus bas.

7. Système de mesure du TAS selon la revendication 5 où le fil formé sur le plan imaginaire en étant enroulé en spirales en avant ou en arrière présente la forme d'un rectangle, d'un cercle, d'un ovale, d'un hexagone ou d'un octogone.

8. Système de mesure du TAS selon la revendication 5 où une couche isolante est formée entre les lignes conductrices pour empêcher une éventuelle mise en court-circuit.

9. Système de mesure du TAS selon la revendication 1 ou 4 où l'antenne est formée de manière que des fils en spirale sont formés sur les parties de films minces diélectriques sur un coté, des orifices transversaux sont formés dans les films minces diélectriques respectifs de telle façon que les orifices transversaux sont alternativement connectés à l'extrémité centrale ou à l'extrémité périphérique du fil, que les films minces diélectriques sont déposés tout en remplissant les orifices transversaux par de la poudre conductrice et une ligne d'alimentation est formée en bas du film mince diélectrique le plus bas de telle façon que la ligne d'alimentation est connectée à l'orifice transversal de celui-ci.

10. Procédé pour mesurer un taux d'absorption spécifique (TAS) comprenant les étapes consistant à :
disposer suivant un motif prédéterminé dans un fantôme muni d'un tissu simulé une pluralité de modules de mesure, chaque module comportant une puce à circuit intégré pour traiter des informations de positionnement et des valeurs mesurées pour générer des signaux, ainsi qu'une antenne pour transmettre les signaux provenant de la puce à circuit intégré, recevant des signaux de fréquence en provenance de l'extérieur pour générer de la puissance induite pour alimenter la puce à circuit intégré et mesurant le TAS absorbé dans le tissu simulé pour transmettre les valeurs TAS mesurées à la puce à circuit intégré ;
monter le produit électronique cible à une position prédéterminée du fantôme avec les modules de mesure ; et
faire fonctionner le produit électronique et une unité de commande de mesure, recevoir les informations de positionnement et les valeurs mesurées provenant des antennes des modules de mesure à l'unité de commande de mesure et traiter les données reçues.
